# EUROPEAN PATENT APPLICATION

(11) **EP 2 750 172 A1**
(43) Date of publication of application: **02.07.2014**
(21) Application number: 13831747.4
(22) Date of filing: 05.08.2013
(51) Int. Cl.: H01L 21/60

(54) **WIRING SUBSTRATE**

(30) Priority: 24.08.2012 JP 2012184962
(71) Applicant: NGK SPARK PLUG CO., LTD., Nagoya Aichi (JP)
(72) Inventor: NISHIDA, Tomohiro, Nagoya-shi Aichi 467-8525 (JP); MORI, Seiji, Nagoya-shi Aichi 467-8525 (JP); WAKAZONO, Makoto, Nagoya-shi Aichi 467-8525 (JP)
(74) Representative: Intès, Didier Gérard André
(86) International application number: PCT/JP2013/004722
(87) International publication number: WO 2014/030309

(57) **Abstract**

A wiring board includes a substrate layer made of an insulative material, an insulating layer laminated on the substrate layer and a connection terminal made of a conductive material. The insulating layer has a first surface formed with an opening, a second surface located inside the opening and recessed toward the substrate layer with respect to the first surface and a wall surface located inside the opening and extending between the first and second surfaces in a lamination direction of the insulating layer relative to the substrate layer. The connection terminal is exposed from the second surface. The second surface extends between the wall surface and the connection terminal and has a curved shape being convex toward the substrate layer and including a deepest part closest to the substrate layer so as to satisfy relationship of L1 > L2 where L1 is a length between the wall surface and the deepest part in a layer in-plane direction perpendicular to the lamination direction; and L2 is a length between the deepest part and the connection terminal in the layer in-plane direction.

## Description

### Field of the Invention

The present invention relates to a wiring board.

### Background Art

A wiring board is known, which is of the type adapted to mount thereon a semiconductor chip (see, for example, Patent Documents 1 and 2). In such a type of wiring board, connection terminals are provided for connection to the semiconductor chip.

Patent Document 1 discloses to form an insulating layer with an opening through which a plurality of connection terminals are exposed, provide an insulating substance between the connection terminals within the opening, and then, perform plating on the connection terminals for the purpose of preventing an electrical short circuit caused between the connection terminals by plating material. Patent Document 2 discloses to, for the purpose of preventing an electrical short circuit caused between connection terminals by soldering, form an insulating layer between the connection terminals and make the thickness of the insulating layer smaller than that of the connection terminals.

When the semiconductor chip is mounted on the wiring board, the connection terminals of the wiring board are soldered to the semiconductor chip; and a liquid curable resin, also called an "underfill", is filled in a clearance around the connection terminals between the wiring board and the semiconductor chip (see, for example, Patent Document 3).

### Prior Art Documents

### Patent Documents

Patent Document 1: Japanese Laid-Open Patent Publication No. 2007-103648
Patent Document 2: Japanese Laid-Open Patent Publication No. 2011-192692
Patent Document 3: Japanese Laid-Open Patent Publication No. 2010-153495

### Summary of the Invention

### Problems to be Solved by the Invention

There is consideration given to the prevention of a short circuit caused between the connection terminals by plating or soldering, but no sufficient consideration given to the filling of the underfill in the clearance around the connection terminals, in Patent Documents 1 and 2. The wiring boards of Patent Documents 1 and 2 thus have the possibility of interfering with the flow of the underfill and forming voids (hollow spaces) due to the poor filling of the underfill.

The wiring board of Patent Document 3 also has the possibility of forming voids due to poor filling of the underfill, since there is no sufficient consideration given to the flow of the underfill after the introduction of the underfill into the clearance between the wiring board and the semiconductor chip.

### Means for Solving the Problems

The present invention has been made to solve the above problems and can be embodied in the following aspects.
(1) According to one aspect of the present invention, there is provided a wiring board, comprising: a substrate layer made of an insulative material; an insulating layer laminated on the substrate layer, the insulating layer having a first surface formed with an opening, a second surface located inside the opening and recessed toward the substrate layer with respect to the first surface and a wall surface located inside the opening and extending between the first and second surfaces in a lamination direction of the insulating layer relative to the substrate layer; and a connection terminal made of a conductive material and exposed from the second surface, wherein the second surface extends between the wall surface and the connection terminal and has a curved shape being convex toward the substrate layer and including a deepest part closest to the substrate layer so as to satisfy relationship of L1 > L2 where L1 is a length between the wall surface and the deepest part in a layer in-plane direction perpendicular to the lamination direction; and L2 is a length between the deepest part and the connection terminal in the layer in-plane direction. By this curved shape, it is possible to improve the flowability of the underfill material and effectively prevent the formation of voids in a region between the second surface and the wall surface as the space located above the second surface and closer to the wall surface than the deepest part becomes narrowed toward the wall surface.
(2) In the wiring board, the deepest part may include a junction of the second surface with the connection terminal. This allows more improvement in the flowability of the underfill as compared to the case where the deepest part is apart from the connection terminal.
(3) In the wiring board, the insulating layer may have a curved surface extending between the first surface and the wall surface in an outwardly convex curved shape. This facilitates the filling of the underfill over the second surface as compared to the case where a square corner is formed between the first surface and the wall surface.
(4) Furthermore, the second surface may have a surface roughness greater than a surface roughness of the first surface in the wiring board. This allows the underfill to spread over the entire second surface by the capillary action without interfering with the flow of the underfill.

The present invention can be embodied in various forms other than the wiring board, e.g., in the form of a device equipped with a wiring board, a production method of a wiring board and the like.

### Brief Description of the Drawings

FIG. 1 is a partial section view schematically showing the configuration of a wiring board according to a first embodiment of the present invention.
FIG. 2 is a partial section view schematically showing the configuration of a wiring board according to a second embodiment of the present invention.
FIG. 3 is a partial section view schematically showing the configuration of a wiring board according to a third embodiment of the present invention.
FIG. 4 is a partial section view schematically showing the configuration of a wiring board according to a fourth embodiment of the present invention.
FIG. 5 is a partial section view schematically showing the configuration of a wiring board according to a fifth embodiment of the present invention.

### Description of the Embodiments

### A. First Embodiment

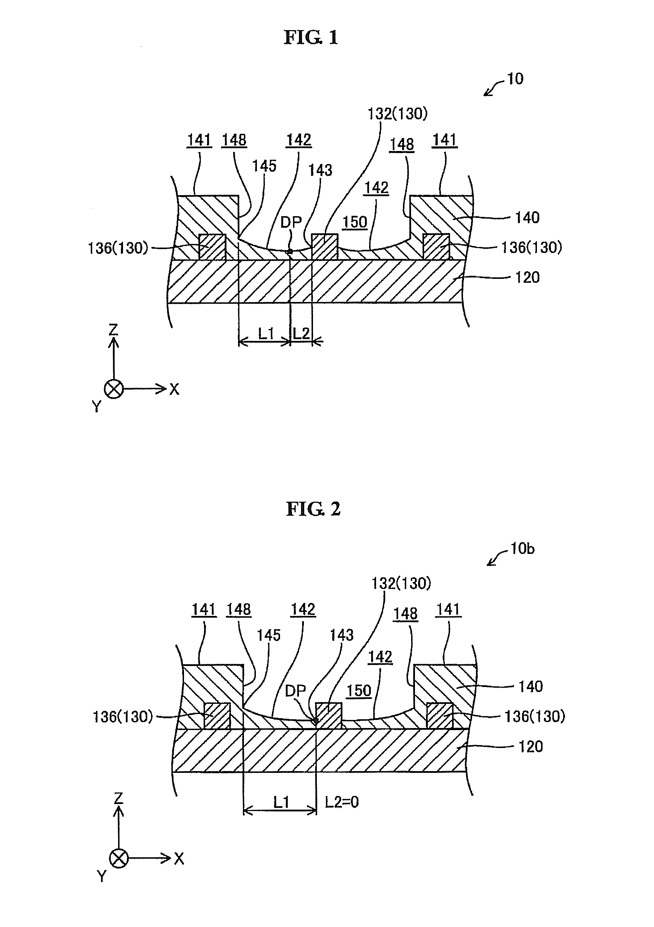

FIG. 1 is a schematic section view of part of a wiring board 10 according to the first embodiment of the present invention. The wiring board 10 is a plate-shaped board produced using an organic material, also called an "organic board", and adapted for flip-chip mounting to mount thereon a semiconductor chip (not shown).

The wiring board 10 includes a substrate layer 120, a conductor layer 130 and an insulating layer 140. In the first embodiment, the wiring board 10 is produced by forming the conductor layer 130 on the substrate layer 120, and then, forming the insulating layer 140 on the conductor layer 130. Alternatively, the wiring board 10 may have a multilayer structure in which a plurality of conductor layers and a plurality of insulating layers are alternately laminated on the substrate layer 120. Such a multilayer structure may be formed on each of both sides of the substrate layer 120.

In FIG. 1, there are illustrated X, Y and Z axes perpendicular to one another. The Z axis refers to one of the axes extending in a lamination direction of the insulating layer 140 relative the substrate layer 120 where a +Z axis direction is defined as a direction from the substrate layer 120 to the insulating layer 140 along the Z axis; and a -Z axis direction is defined as a direction opposite the +Z axis direction. The X and Y axes refer to the other two of the axes extending in a layer in-plane direction perpendicular to the Z axis where a +X axis direction is defined as a direction from the left to right side along the X axis in FIG. 1; a -X axis direction is defined as a direction opposite the +X axis direction; a +Y axis direction is defined as a direction from the front to back side along the Y axis in FIG. 1; and a -Y axis direction is defined as a direction opposite the +Y axis direction.

The substrate layer 120 of the wiring board 10 is a plate-shaped member made of an insulative material. In the first embodiment, a thermosetting resin such as bismaleimide-triazine resin (BT) or epoxy resin is used as the insulative material of the substrate layer 120. The insulative material of the substrate layer 120 may be a fiber reinforced resin (such as glass-fiber reinforced epoxy resin). Although not shown in FIG. 1, through holes and through-hole conductors may be formed in the substrate layer 120 as a part of wiring for connection to the conductor layer 130.

The conductor layer 130 of the wiring board 10 is a conductor pattern made of a conductive material and formed on the substrate layer 120. In the first embodiment, the conductor layer 130 is formed by applying a copper plating layer to a surface of the substrate layer 120 and etching the copper plating layer into a desired shape.

The conductor layer 130 has connection terminals 132 and inner wiring lines 136. The connection terminal 132 of the conductor layer 130 is a part of the conductor pattern exposed through the insulating layer 140 for connection to the semiconductor chip (not shown). On the other hand, the inner wiring line 136 is a part of the conductor pattern covered with the insulating layer 140.

The insulating layer 140 of the wiring board 10 is a layer of an insulative material, also called a "solder resist". The insulating layer 140 has a first surface 141, a second surface 142 and a wall surface 148.

The first surface 141 is a surface of the insulating layer 140 in which an opening 150 is formed. In the first embodiment, the first surface 141 is oriented along the X and Y axes and directed toward the +Z axis direction so as to constitute a part of a +Z axis direction side surface of the insulating layer 140

The second surface 142 is a surface of the insulating layer 140 located inside the opening 150 and recessed toward the substrate layer 120 with respect to the first surface 141. The connection terminal 132 of the conductor layer 130 is exposed from the second surface 142 and protrudes in the +Z axis direction from the second surface 142 in the first embodiment. When the semiconductor chip is mounted onto the wiring board 10, the connection terminal 132 is soldered to the semiconductor chip; and an underfill is filled in a clearance within the opening 150 between the wiring board 10 and the semiconductor chip.

The second surface 142 extends between the wall surface 148 and the connection terminal 132 in a curved shape, which is convex toward the substrate layer 120 (the -Z axis direction), so as to constitute a part of the +Z axis direction side surface of the insulating layer 140 within the opening 150. The second surface 142 has a deepest part DP located closest to the substrate layer 120 (i.e. recessed most deeply toward the -Z axis direction).

Herein, there is satisfied a relationship of L1 > L2 where L1 is a length between the wall surface 148 and the deepest part DP in the X axis direction, that is, the layer in-plane direction across the connection terminal 132; and L2 is a length between the deepest part DP and the connection terminal 132 in the X axis direction. A corner 145 between the second surface 142 and the wall surface 148 is a base point of the length L1. A junction 143 of the second surface 142 with the connection terminal 132 is a base point of the length L2.

Further, the second surface 142 has a surface roughness greater than that of the first surface 141 in the first embodiment. More specifically, the second surface 142 has a center-line average roughness Ra of 0.06 to 0.8 µm (micrometer) and a ten-point average roughness Rz of 1.0 to 9.0 µm in the first embodiment. As compared to such a surface roughness of the second surface 142, the first surface 141 has a center-line average roughness Ra of 0.02 to 0.25 µm and a ten-point average roughness Rz of 0.6 to 5.0 µm.

The wall surface 148 of the insulating layer 140 is a surface extending between the first and second surfaces 141 and 142 in the lamination direction (the Z axis direction). As shown in FIG. 1, the wall surface 148 is connected to the first surface 141 so as to form a square corner therebetween in the first embodiment.

In the first embodiment, the insulating layer 140 is formed by applying a photo-curable insulating resin to the substrate layer 120 on which the conductor layer 130 has been formed, and then, subjecting the resulting photo-curable resin film to exposure and development. The opening 150 of the insulating layer 140 corresponds to a part of the photo-curable resin film masked during the exposure. The second surface 142 and the wall surface 148 are formed by washing the uncured part of the photo-curable resin film away during the development. In this way, the first surface 141, the second surface 142 and the wall surface 148 are integrally formed to constitute the single insulating layer 140. The shapes of the second surface 142 and the wall surface 148 are attained by controlling the kind of the photo-curable insulating resin used, the shape of the mask used during the exposure, the intensity, irradiation time and irradiation angle of the light irradiated during the exposure etc. in the first embodiment.

Although one connection terminal 132 is shown between the +X and -X axis direction sides of the wall surface 148 in FIG. 1, two or more connection terminals 132 may be provided between the +X and -X axis direction sides of the wall surface 148. The connection terminal 132 and the insulating layer 140 may be configured in the Y axis direction in the same manner as in the X axis direction although not shown in FIG. 1.

As explained above, the second surface 142 is formed into a curved shape so as to satisfy the relationship of L1 > L2 in the first embodiment. By this curved shape, it is possible to improve the flowability of the underfill and effectively prevent the formation of voids at around the corner 145 between the second surface 142 and the wall surface 148 as the space located above the second surface 142 and closer to the wall surface 148 than the deepest part DP becomes narrowed toward the wall surface 148. Further, the surface

roughness of the second surface 142 is made greater than the surface roughness of the first surface 141. This allows the underfill to spread over the entire second surface 142 by the capillary action without interfering with the flow of the underfill.

### B. Second Embodiment

FIG. 2 is a schematic section view of part of a wiring board 10b according to the second embodiment. Herein, the same constituent parts of the second embodiment as those of the first embodiment are denoted by the same reference numerals to avoid duplicating explanation thereof.

The wiring board 10b of the second embodiment is the same as the wiring board 10 of the first embodiment, except for the shape of the second surface 142. In the second embodiment, the deepest part DP of the second surface 142 is located at the junction 143 although the deepest part DP of the second surface 142 is located between the junction 143 and the corner 145 in the first embodiment. Namely, the junction 143 is included in the deepest part DP so that the lengths L1 and L2 satisfy the relationship of L1 > L2 = 0 in the second embodiment.

As explained above, the second surface 142 is formed into a curved shape so as to satisfy the relationship of L1 > L2 = 0 in the second embodiment. In this case, it is possible to allow more improvement in the flowability of the underfill as compared to the first embodiment and effectively prevent the formation of voids at around the corner 145 between the second surface 142 and the wall surface 148 as the space located above the second surface 142 and closer to the wall surface 148 than the deepest part DP becomes narrowed toward the wall surface 148.

### C. Third Embodiment

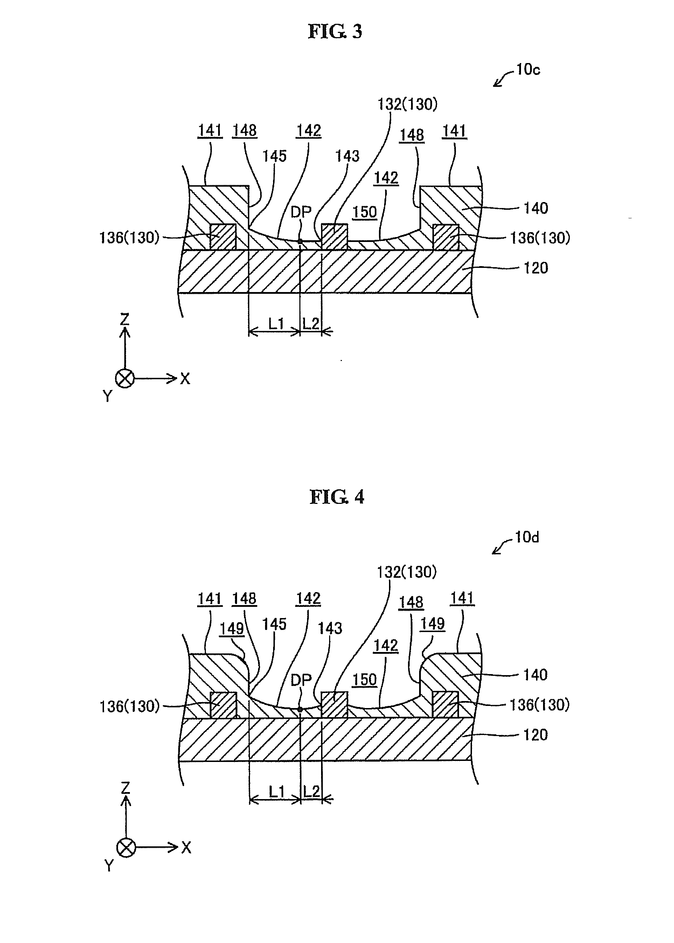

FIG. 3 is a schematic section view of part of a wiring board 10c according to the third embodiment. Herein, the same constituent parts of the third embodiment as those of the first embodiment are denoted by the same reference numerals to avoid duplicating explanation thereof.

The wiring board 10c of the third embodiment is the same as the wiring board 10 of the first embodiment, except for the shape of the second surface 142. In the third embodiment, the deepest part DP of the second surface 142 is defined as a first appearing point closest to the substrate layer 120 side (-Y axis direction side) in the midway from the wall surface 148 to the junction 143. Although the second surface 142 rises up from the deepest part DP to the junction 143 in the +Z axis direction in the first embodiment, the second surface 142 extends from the deepest part DP to the junction 143 in parallel to the X axis in the third embodiment. The lengths L1 and L2 thus satisfy the relationship of L1 > L2 in the third embodiment as in the case of the first embodiment.

It is therefore possible in the third embodiment to effectively prevent the formation of voids at around the corner 145 between the second surface 142 and the wall surface 148 in the same manner as in the first embodiment.

### D. Fourth Embodiment

FIG. 4 is a schematic section view of part of a wiring board 10d according to the fourth embodiment. Herein, the same constituent parts of the fourth embodiment similar as those of the first embodiment are denoted by the same reference numerals to avoid duplicating explanation thereof.

The wiring board 10d of the fourth embodiment is the same as the wiring board 10 of the first embodiment, except that the insulating layer 140 has a curved surface 149 extending in an outwardly convex curved shape between the first surface 141 and the wall surface 148. The shape of the curved surface 149 is attained by controlling the kind of the photo-curable insulating resin used, the shape of the mask used during the exposure, the intensity, irradiation time and irradiation angle of the light irradiated during the exposure etc. as in the case of the second surface 142 and the wall surface 148.

It is therefore possible in the fourth embodiment to effectively prevent the formation of voids at around the corner 145 between the second surface 142 and the wall surface 148 in the same manner as in the first embodiment. Further, the curved surface 149 is formed between the first surface 141 and the wall surface 148 in the fourth embodiment. This facilitates the filling of the underfill over the second surface 142 as compared to the case where the square corner is formed between the first surface 141 and the wall surface 148 as in the first embodiment. As a modification of the fourth embodiment, the curved surface 149 may be applied to the wiring board 10b of the second embodiment or the wiring board 10c of the third embodiment.

### E. Fifth Embodiment

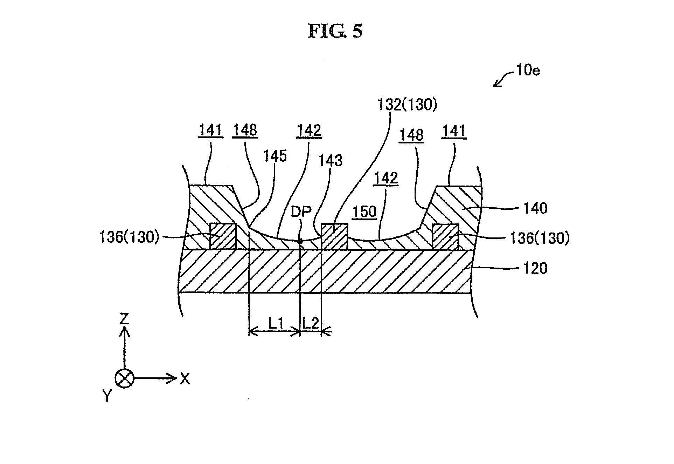

FIG. 5 is a schematic section view of part of a wiring board 10e according to the fifth embodiment. Herein, the same constituent parts of the fifth embodiment as those of the first embodiment are denoted by the same reference numerals to avoid duplicating explanation thereof.

The wiring board 10e of the fifth embodiment is the same as the wiring board 10 of the first embodiment, except that the wall surface 148 is inclined outwardly of the opening 150 with respect to the +Z axis direction. The shape of the wall surface 148 in the fifth embodiment is attained by controlling the kind of the photo-curable insulating resin used, the shape of the mask used during the exposure, the intensity, irradiation time and irradiation angle of the light irradiated during the exposure etc.

Although there is an angular corner formed between the first surface 141 and the wall surface 148 in the fifth embodiment, a curved surface 149 may alternatively be formed between the first surface 141 and the wall surface 148 as in the fourth embodiment. The shape of the second surface 142 in the fifth embodiment is the same as that in the first embodiment but may alternatively be the same as that in the second embodiment or third embodiment.

It is therefore possible in the fifth embodiment to effectively prevent the formation of voids at around the corner 145 between the second surface 142 and the wall surface 148 in the same manner as in the first embodiment. Further, the wall surface 148 is inclined outwardly of the opening 150 with respect to the +Z axis direction in the firth embodiment. This leads to more improvement in the flowability of the underfill.

### F. Other Embodiments

The present invention is not limited to the above aspects, embodiments and modifications/variations and can be embodied in various forms without departing from the scope of the present invention. For example, it is feasible to appropriately replace or combine any of the technical features of the aspects of the present invention described in "Summary of the Invention" and the technical features of the embodiments and modifications/variations of the present invention in order to solve part or all of the above-mentioned problems or achieve part or all of the above-mentioned effects. Any of these technical features, if not explained as essential in the present specification, may be deleted as appropriate.

In the above embodiments, the second surface 142 and the wall surface 148 of the insulating layer 140 may be formed by the following steps.
Step 1: The photo-curable insulating resin as the material of the insulating layer 140 is applied or laminated to the substrate layer 120 on which the conductor layer 130 has been formed.
Step 2: After the step 1, the thus-formed photo-curable insulating resin film on the substrate layer 120 is subjected to pattern exposure.
Step 3: After the step 2, the uncured part of the photo-curable resin film on the substrate layer 120 is removed by development with an aqueous alkali solution such that the connection terminal 132 is exposed from the insulating layer 140.
Step 4: After the step 3, the insulating layer 140 is cured by heating (thermal curing) and cured by irradiation with ultraviolet light (photocuring).

The accumulated amount of the light irradiated for the photocuring in the step 4 is preferably 500 to 2500 mJ/cm² (milijoule per square centimeter), more preferably 1000 to 2000 mJ/cm²_{.}

### Description of Reference Numerals

- 10, 10b, 10c, 10d, 10e:: Wiring board
- 120:: Substrate layer
- 130:: Conductor layer
- 132:: Connection terminal
- 136:: Inner wiring line
- 140:: Insulating layer
- 141:: First surface
- 142:: Second surface
- 143:: Junction
- 145:: Corner
- 148:: Wall surface
- 149:: Curved surface
- 150:: Opening
- DP:: Deepest part

## Claims

1. A wiring board, comprising:
a substrate layer made of an insulative material;
an insulating layer laminated on the substrate layer, the insulating layer having a first surface formed with an opening, a second surface located inside the opening and recessed toward the substrate layer with respect to the first surface and a wall surface located inside the opening and extending between the first and second surfaces in a lamination direction of the insulating layer relative to the substrate layer; and
a connection terminal made of a conductive material and exposed from the second surface,
wherein the second surface extends between the wall surface and the connection terminal and has a curved shape being convex toward the substrate layer and including a deepest part closest to the substrate layer so as to satisfy relationship of L1 > L2 where L1 is a length between the wall surface and the deepest part in a layer in-plane direction perpendicular to the lamination direction; and L2 is a length between the deepest part and the connection terminal in the layer in-plane direction.

2. The wiring board according to claim 1, wherein the deepest part includes a junction of the second surface with the connection terminal.

3. The wiring board according to claim 1 or 2, wherein the insulating layer has a curved surface extending between the first surface and the wall surface in an outwardly convex curved shape.

4. The wiring board according to any one of claims 1 to 3, wherein the second surface has a surface roughness greater than a surface roughness of the first surface.
